# EUROPÄISCHE PATENTANMELDUNG

(11) **EP 2 209 147 A1**
(43) Veröffentlichungstag der Anmeldung: **21.07.2010**
(21) Anmeldenummer: 10160351.2
(22) Anmeldetag: 27.04.2001
(51) Int. Cl.: H01L 51/42

(54) **Photovoltaische Zelle**

(30) Priorität: 27.04.2000 AT 7332000
(62) Teilanmeldung aus: 01925189.1
(71) Anmelder: Konarka Austria Forschungs und Entwicklungs GmbH, 4010 Linz (AT)
(72) Erfinder: Shaheen, Sean, Arizona, AZ 85331 (US); Brabec, Christoph, 4040, Linz (AT); Fromherz, Thomas, 4112, Rottenegg (AT); Padinger, Franz, 4490, St. Florian (AT); Sariciftci, Sedar, 4040, Linz (AT); Gloetzl, Erhard, 4020, Linz (AT)
(74) Vertreter: Sutto, Luca

(57) **Zusammenfassung**

Es wird eine photovoltaische Zelle mit einer photoaktiven Schicht (4) aus zwei Komponenten, nämlich einer konjugierten Polymerkomponente als Elektronendonator und einer Fullerenkomponente als Elektronenakzeptor, beschrieben. Um vorteilhafte Bedingungen zu schaffen, wird vorgeschlagen, daß die beiden Komponenten und deren Mischphasen zumindest in Abschnitten der photoaktiven Schicht (4) eine durchschnittliche größte Korngröße kleiner als 500 nm aufweisen.

## Beschreibung

Die Erfindung bezieht sich auf eine photovoltaische Zelle mit einer photoaktiven Schicht aus zwei Komponenten, nämlich einer konjugierten Polymerkomponente als Elektronendonator und einer Fullerenkomponente als Elektronenakzeptor.

Kunststoffe mit ausgedehnten π-Elektronensystemen, bei denen abwechselnd Einfach- und Doppelbindungen aufeinanderfolgen, werden als konjugierte Kunststoffe bezeichnet. Diese konjugierten Kunststoffe weisen hinsichtlich der Elektronenenergie mit Halbleitern vergleichbare Energiebänder auf, so daß sie auch durch ein Dotieren vom nichtleitenden, in den metallisch leitenden Zustand überführt werden können. Beispiele für solche konjugierten Kunststoffe sind Polyphenylene, Polyvinylphenylene (PPV), Polythiophene oder Polyaniline. Der Wirkungsgrad der Energieumwandlung von photovoltaischen Polymerzellen aus einem konjugierten Polymer liegt allerdings typischerweise zwischen 10⁻³ und 10⁻² %. Zur Verbesserung dieses Wirkungsgrades wurden zwar bereits heterogene Schichten aus zwei konjugierten Polymerkomponenten vorgeschlagen (US 5 670 791 A), von denen eine Polymerkomponente als Elektronendonator und die andere Polymerkomponente als Elektronenakzeptor dienen. Durch den Einsatz von Fullerenen, insbesondere Buckminsterfullerenen C₆₀, als Elektronenakzeptoren (US 5 454 880 A) konnte die sonst übliche Ladungsträgerrekombination in der photoaktiven Schicht weitgehend vermieden werden, was zu einer Wirkungsgradsteigerung auf 0,6 % bis 1 % unter AM (Air Mass) 1,5 Bedingungen führte. Trotzdem bleibt der erreichbare Wirkungsgrad für einen wirtschaftlichen, technischen Einsatz von solchen photoaktiven Schichten zum Aufbau von photovoltaischen Zellen im allgemeinen zu gering.

Der Erfindung liegt somit die Aufgabe zugrunde, eine photovoltaische Zelle der eingangs geschilderten Art so auszugestalten, daß eine weitere Steigerung des Wirkungsgrades der Energieumwandlung möglich wird.

Die Erfindung löst die gestellte Aufgabe dadurch, daß die beiden Komponenten und deren Mischphasen zumindest in Abschnitten der photoaktiven Schicht eine durchschnittliche größte Korngröße kleiner als 500 nm aufweisen.

Der Erfindung liegt die Erkenntnis zugrunde, daß eine wirksame Ladungstrennung nur im Berührungsbereich zwischen dem Elektronendonator und dem Elektronenakzeptor sichergestellt werden kann, so daß nach einer Photoanregung der konjugierten Polymerkomponente die Anregungsenergie nur in den Berührungsbereichen mit der Fullerenkomponente an diese in Form von Elektronen weitergegeben wird. Wird die durchschnittliche größte Korngröße der Komponenten und Mischphasen der photoaktiven Schicht kleiner als 500 nm gehalten, so kann aufgrund der damit verbundenen Oberflächenvergrößerung der Berührungsanteil zwischen den beiden Komponenten entsprechend gesteigert werden, was zu einer deutlichen Verbesserung der Ladungstrennung führt. Der von dieser Ladungstrennung abhängige Wirkungsgrad stieg auf kennzeichnende 2,5 % unter simulierten AM 1,5 Bedingungen.

Zur Herstellung photovoltaischer Zellen mit einer photoaktiven Schicht, deren durchschnittliche Korngröße kleiner als 500 nm ist, kann in üblicher Weise eine Mischung aus den beiden Komponenten und einem Lösungsmittel als Film auf eine mit einer Elektrodenschicht versehene Trägerschicht aufgebracht werden, bevor dieser die photoaktive Schicht bildende Film mit einer Gegenelektrode abgedeckt wird. Es muß jedoch dafür gesorgt werden, daß als Lösungsmittel ein entsprechendes Feinungsmittel für die beiden Komponenten eingesetzt wird, um die angestrebte Feinkörnigkeit der photoaktiven Schicht sicherzustellen. Mit besonderem Vorteil kann dabei Chlorbenzol als Feinungsmittel eingesetzt werden.

Anhand der Zeichnung wird die Wirkung der feinkörnigen Strukturierung der photoaktiven Schicht einer erfindungsgemäßen photovoltaischen Zelle näher erläutert. Es zeigen
- Fig. 1: den grundsätzlichen Aufbau einer erfindungsgemäßen photovoltaischen Zelle in einem Schnitt,
- Fig. 2: die Oberflächenstruktur einer herkömmlichen photoaktiven Schicht,
- Fig. 3: die Oberflächenstruktur einer erfindungsgemäßen photoaktiven Schicht,
- Fig. 4: die Strom-Spannungskennlinie einer herkömmlichen und einer erfindungsgemäßen photovoltaischen Zelle und
- Fig. 5: die auf die Wellenlänge der Photoanregung bezogene Ladungsausbeute je einfallender Lichtleistung einerseits für eine herkömmliche und anderseits für eine erfindungsgemäße photovoltaische Zelle.

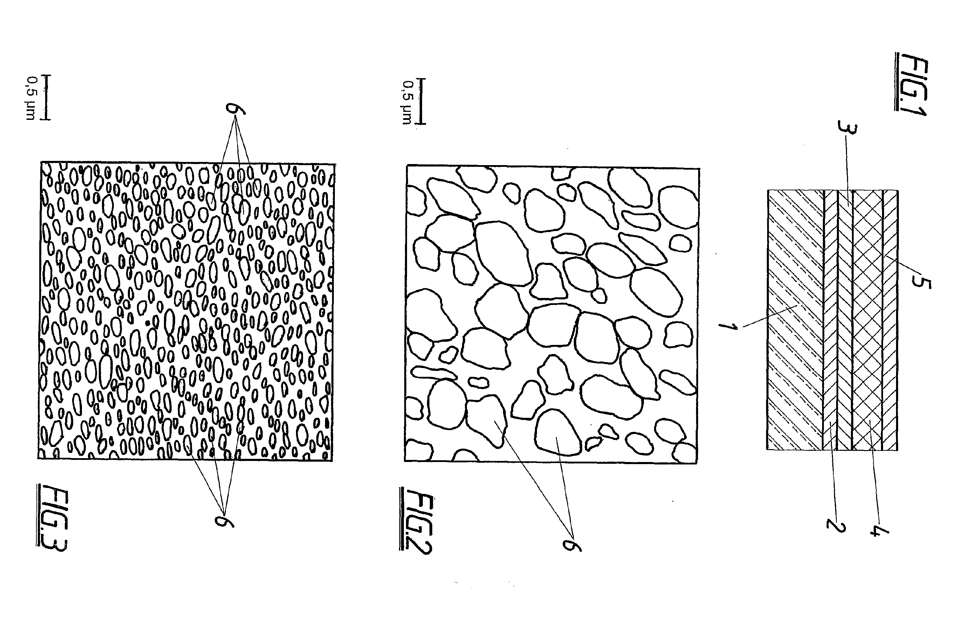

Gemäß der Fig. 1 besteht die photovoltaische Zelle aus einem lichtdurchlässigen Glasträger 1, auf dem eine Elektrodenschicht 2 aus einem Iridium/Zinn-Oxid (ITO) aufgebracht ist. Diese Elektrodenschicht 2 weist im allgemeinen eine vergleichsweise rauhe Oberflächenstruktur auf, so daß sie mit einer Glättungsschicht 3 aus einem durch eine Dotierung elektrisch leitfähig gemachten Polymer, üblicherweise PEDOT, abgedeckt wird. Auf diese Glättungsschicht 3 wird die photoaktive Schicht 4 aus zwei Komponenten mit einer Schichtdicke je nach Auftragungsverfahren von beispielsweise 100 nm bis einige µm aufgetragen, bevor die Gegenelektrode 5 aufgebracht wird. Bei der Verwendung von ITO als lochsammelnde Elektrode wird als elektronensammelnde Elektrode Aluminium eingesetzt, das auf die photoaktive Schicht 4 aufgedampft wird.

Die photoaktive Schicht besteht aus einem konjugierten Polymer, vorzugsweise einem PPV-Derivat, als Elektronendonator und einem Fulleren, insbesondere funktionalisiertes Fulleren PCBM, als Elektronenakzeptor. Unter dem Begriff Polymer sind dabei sowohl Hochpolymere als auch Oligomere zu verstehen. Diese beiden Komponenten werden mit einem Lösungsmittel vermischt und als Lösung auf die Glättungsschicht 3 z. B. durch Aufschleudern oder Auftropfen aufgetragen. Als übliches Lösungsmittel wird Toluol eingesetzt, das jedoch nicht die gewünschte Feinstruktur der photoaktiven Schicht 4 sicherstellen kann, wie dies die Fig. 2 zeigt, in der die typische Oberflächenstruktur einer solchen photoaktiven Schicht mit Toluol als Lösungsmittel dargestellt ist. Es läßt sich in einer Atomkraftaufnahme (Tapping-mode AFM images), wie sie in den Fig. 2 und 3 schematisch wiedergegeben ist, insbesondere die Kornstruktur der Fullerenkomponente 6 bzw. einer Mischphase entnehmen, während die Polymerkomponente bzw. eine weitere Mischphase im wesentlichen die Zwischenräume zwischen den ausgeprägten Körnern ausfüllt. Anhand der eingezeichneten Längeneinheit ergibt sich eine maximale Korngröße erheblich größer als 500 nm.

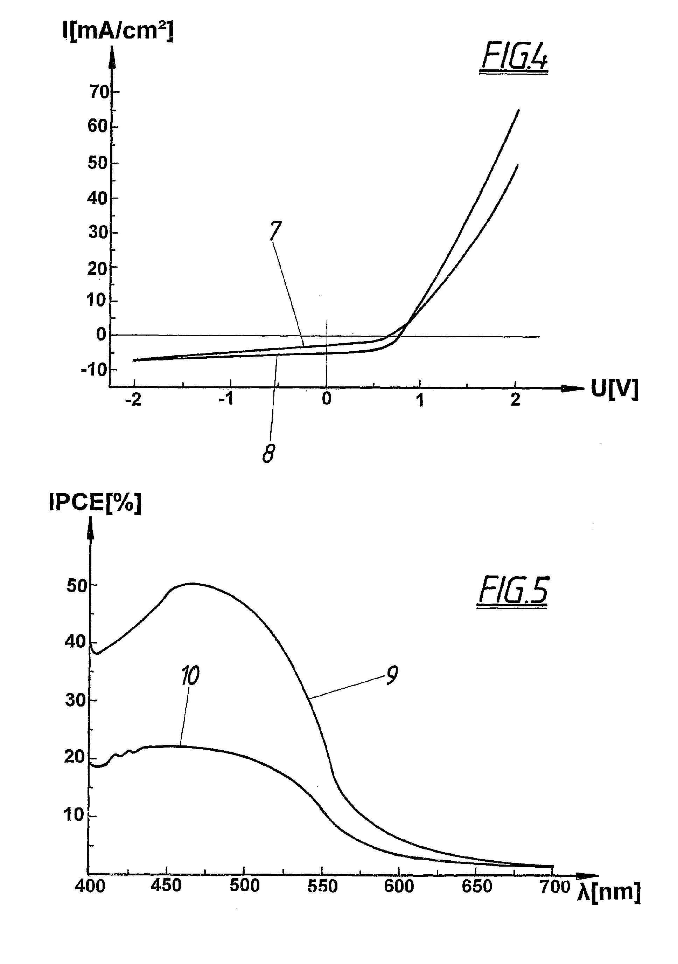

Wird jedoch erfindungsgemäß als Lösungsmittel ein Feinungsmittel, vorzugsweise Chlorbenzol, eingesetzt, so erhält man bei sonst übereinstimmender Zusammensetzung der aktiven Schicht 4 eine erheblich feinere Struktur, die sich gemäß der Fig. 3 in einer entsprechend glatteren Oberflächenstruktur auswirkt. Die mit Hilfe des Feinungsmittels erzielbare durchschnittliche Korngröße kleiner als 500 nm der photoaktiven Schicht 4 bringt eine deutliche Vergrößerung der Anzahl der Berührungsstellen zwischen dem Elektronendonator und dem Elektronenakzeptor und damit eine erheblich verbesserte Ladungstrennung und verringerte Ladungsrekombination mit sich, was aus den Spannungs-Stromkennlinien unmittelbar abgelesen werden kann. In der Fig. 4 ist die Stromdichte I der zu vergleichenden photovoltaischen Zellen über der Spannung U aufgetragen, und zwar bei einer Anregungsenergie von 80 mW/cm² unter simulierten AM 1,5 Bedingungen. Vergleicht man die Kennlinie 7 der photovoltaischen Zelle mit der grobkörnigeren Struktur der photoaktiven Schicht 4 mit der Kennlinie 8, die für eine photovoltaische Zelle mit einer feinkörnigen Struktur der photoaktiven Schicht 4 aufgenommen wurde, so erkennt man unmittelbar die verbesserten Verhältnisse bei einer erfindungsgemäßen photovoltaischen Zelle gemäß der Kennlinie 8. Der bei der Spannung 0 V gemessene Kurzschlußstrom betrug bei der bekannten Zelle 2,79 mA/cm², bei der erfindunggemäßen Zelle 5,24 mA/cm². Da sich auch die Leerlaufspannung von 710 mV auf 770 mV vergrößerte, konnte eine Wirkungsgradsteigerung von ca. 1 % auf 2,6 % erzielt werden, wobei zu berücksichtigen ist, daß sich der Füllfaktor aufgrund der feineren Struktur der erfindungsgemäßen photoaktiven Schicht von 0,40 auf 0,52 vergrößerte.

Besonders deutlich sind die erfindungsgemäßen Wirkungen anhand der Fig. 5 abzulesen, in der die Ladungsausbeute je einfallender Lichtleistung IPCE[%] = 1240.lₖ[µA/cm²] / λ[nm].Iₗ[W/m²] über der Wellenlänge λ für die zu vergleichenden photovoltaischen Zellen aufgetragen ist. Mit Iₖ ist der Kurzschlußstrom und mit I₁ die Lichtleistung in die obige Formel einzutragen. Es zeigt sich, daß gemäß der Kennlinie 9 für eine erfindungsgemäße Zelle im Vergleich zur Kennlinie 10 der herkömmlichen Zelle ca. die doppelte Ladungsausbeute je einfallender Lichtleistung anfällt, wenn die Feinstruktur der heterogenen photoaktiven Schicht 4 eine durchschnittliche Körnung kleiner als 500 nm aufweist.

Obwohl die vorliegende Erfindung oben beschrieben wurde, und in den beigefügten Ansprüchen definiert ist, sollte verstanden werden, dass die Erfindung alternativ auch entsprechend der folgenden Ausführungsformen definiert werden kann:
1. Photovoltaische Zelle mit einer photoaktiven Schicht (4) aus zwei Komponenten, nämlich einer konjugierten Polymerkomponente als Elektronendonator und einer Fullerenkomponente als Elektronenakzeptor, **dadurch gekennzeichnet, dass** die beiden Komponenten und deren Mischphasen zumindest in Abschnitten der photoaktiven Schicht (4) eine durchschnittliche grösste Korngrösse kleiner als 500 nm aufweisen.
2. Verfahren zum Herstellen einer photovoltaischen Zelle nach Ausführungsform 1, wobei eine Mischung aus den beiden Komponenten und einem Lösungsmittel auf einer mit einer Elektrodenschicht versehenen Trägerschicht als Film aufge- bracht und dann dieser Film mit einer Gegenelektrode abgedeckt wird, **dadurch gekennzeichnet, dass** der Mischung aus den beiden Komponenten ein Feinungsmittel, vorzugsweise Chlorbenzol, als Lösungsmittel beigefügt wird.

## Patentansprüche

1. Verfahren zum Herstellen einer photovoltaischen Zelle mit einer photoaktiven Schicht (4) aus zwei Komponenten, nämlich einer konjugierten Polymerkomponente als Elektronendonator und einer Fullerenkomponente als Elektronenakzeptor, wobei die beiden Komponenten und deren Mischphasen zumindest in Abschnitten der photoaktiven Schicht (4) eine durchschnittliche größte Komgrösse kleiner als 500 nm aufweisen, wobei eine Mischung aus den beiden Komponenten und einem Lösungsmittel auf einer mit einer Elektrodenschicht (2) versehenen Trägerschicht (1) als Film aufgebracht und dann dieser Film mit einer Gegenelektrode (5) abgedeckt wird,
**dadurch gekennzeichnet, dass** der Mischung aus den beiden Komponenten ein Feinungsmittel, vorzugsweise Chlorbenzol, als Lösungsmittel beigefügt wird.

2. Das Verfahren nach Anspruch 1, wobei das Feinungsmittel Chlorbenzol ist.

3. Das Verfahren nach Anspruch 1 oder 2, wobei die konjugierten Polymerkomponente ein PPV-Derivat ist.

4. Das Verfahren nach einem der Ansprüche 1 bis 3, wobei die Elektrodenschicht (2) abgedeckt wird mit einer Glättungsschicht (3) aus einem durch Dotierung elektrisch leitfähig gemachtem Polymer.

5. Das Verfahren nach Anspruch 4, wobei die Mischung auf die Glättungsschicht (3) durch Aufschleudem oder Auftropfen aufgetragen wird.

6. Das Verfahren nach Anspruch 4 oder 5, wobei das Polymer der Glättungsschicht (3) PEDOT ist.
